# EUROPEAN PATENT SPECIFICATION

(11) **EP 3 807 209 B1**
(45) Date of publication and mention of the grant of the patent: **24.04.2024**
(21) Application number: 19780466.9
(22) Date of filing: 17.09.2019
(51) Int. Cl.: B81B 7/00

(54) **SENSOR WITH INTEGRATED HEATER**
SENSOR MIT INTEGRIERTER HEIZUNG
CAPTEUR POURVU D'UN DISPOSITIF DE CHAUFFAGE INTÉGRÉ

(30) Priority: 17.09.2018 US 201862732325 P
(43) Date of publication of application: 21.04.2021
(73) Proprietor: InvenSense, Inc., San Jose, CA 95110 (US)
(72) Inventor: YEN, Pei-Wen, Hsinchu City (TW); LIU, Ting-Yuan, Zhubei City, Hsinchu County, 302 (TW); REN, Jye, Taipei City, 106 (TW); LIN, Chung-Hsien, Hsinchu City (TW); SEEGER, Joseph, Menlo Park, CA 94025 (US); MICLAUS, Calin, Fremont, CA 94536 (US)
(74) Representative: St Clair Jones, Gregory Arthur Langley
(86) International application number: PCT/US2019/051611
(87) International publication number: WO 2020/061121

(56) References cited:
- US-A1- 2010 300 201
- US-A1- 2018 044 173

## Description

### RELATED APPLICATIONS

The instant application is a non-provisional patent application claiming the benefit and priority to the U.S. Provisional Application Number 62/732,325 filed on September 17, 2018. The instant application is a continuation-in-part non-provisional patent application and claims the benefit and priority to a U.S. Application 16/520,228 filed on July 23, 2019. The instant application is also a continuation-in-part non-provisional patent application and claims the benefit and priority to a U.S. Application 16/378,322 filed on April 8, 2019.

### BACKGROUND

Many electronic devices are used in various conditions and are exposed to different external environments. For example, sensors may come in contact with the external environment such as water that may be damaging to the sensing device in addition to causing performance degradation. Unfortunately, sensors are sensitive to these external environments, e.g., water droplets on the membrane may cause an offset resulting in performance degradation. Moreover, electronic devices may be used in different temperature conditions. Unfortunately, sensor performance shifts after it is installed on a board, e.g., soldered on a printed circuit board (PCB), due to temperature dependent parameters, e.g., temperature coefficient of offset (TCO). Some attempts have been made to address performance degradation by using calibration algorithm to compensate for temperature effect before the sensor is installed, hence soldered on a board. Unfortunately, calibration algorithm used before soldering the sensor does not address or compensate for temperature coefficient offset resulting after soldering the sensor.

US2018044173A1 describes a temperature-stabilized MEMS device in which heat is generated by ohmic heating as an electric current passes through at least part of one of the structural layers of the device. Various implementation options are disclosed in which the heating occurs in a device layer of the device, either in an outer frame or within the area of an active structure, or where heating occurs within a substrate or a cover of the device. One application of particular relevance is a gyroscope device.

### SUMMARY

Accordingly, a need has arisen to calibrate the sensor after it is soldered on a board in order to address temperature coefficient offset. Furthermore, a need has arisen to address and remove liquid from the sensor environment when liquid is detected.

A device according to the present invention is described in claim 1.

Various features and aspects of the device of the present invention may be better understood with reference to the following drawings and their explanation where all embodiments referred to are examples which help to understand the invention as claimed.

### BRIEF DESCRIPTION OF DRAWINGS

Figures 1A-1B show a top view and a cross-sectional view of a sensor with heater integrated therein in accordance with some embodiments.
Figure 2 shows a sensor device with a heater integrated therein configured to heat to evaporate water droplets on its deformable membrane in accordance with some embodiments.
Figure 3 shows another sensor device with a heater integrated therein in accordance with some embodiments.
Figure 4 shows yet another sensor device with a heater integrated therein in accordance with some embodiments.
Figure 5 shows an alternative sensor device with a heater integrated therein in accordance with some embodiments.
Figures 6A-6B show top views of a sensor with different heater configuration integrated therein in accordance with some embodiments.

### DETAILED DESCRIPTION

Before various embodiments are described in greater detail, it should be understood by persons having ordinary skill in the art that the embodiments are not limiting, as elements in such embodiments may vary. It should likewise be understood that a particular embodiment described and/or illustrated herein has elements which may be readily separated from the particular embodiment and optionally combined with any of several other embodiments or substituted for elements in any of several other embodiments described herein.

It should also be understood by persons having ordinary skill in the art that the terminology used herein is for the purpose of describing the certain concepts, and the terminology is not intended to be limiting. Unless indicated otherwise, ordinal numbers (e.g., first, second, third, etc.) are used to distinguish or identify different elements or steps in a group of elements or steps, and do not supply a serial or numerical limitation on the elements or steps of the embodiments thereof. For example, "first," "second," and "third" elements or steps need not necessarily appear in that order, and the embodiments thereof need not necessarily be limited to three elements or steps. It should also be understood that, unless indicated otherwise, any labels such as "left," "right," "front," "back," "top," "middle," "bottom," "forward," "reverse," "clockwise," "counter clockwise," "up," "down," or other similar terms such as "upper," "lower," "above," "below," "vertical," "horizontal," "proximal," "distal," "periphery", "outer", and the like are used for convenience and are not intended to imply, for example, any particular fixed location, orientation, or direction. Instead, such labels are used to reflect, for example, relative location, orientation, or directions. It should also be understood that the singular forms of "a," "an," and "the" include plural references unless the context clearly dictates otherwise.

Unless defined otherwise, all technical and scientific terms used herein have the same meaning as commonly understood by persons of ordinary skill in the art to which the embodiments pertain.

Many electronic devices are used in various conditions and are exposed to different external environments. For example, sensors may come in contact with the external environment such as water that may be damaging to the sensing device in addition to causing performance degradation. Unfortunately, sensors are sensitive to these external environments, e.g., water droplets on the membrane may cause an offset resulting in performance degradation. Moreover, electronic devices may be used in different temperature conditions. Unfortunately, sensor performance shifts after it is installed on a board, e.g., soldered, due to temperature dependent parameters, e.g., temperature coefficient of offset (TCO). Some attempts have been made to address performance degradation by using calibration algorithm to compensate for temperature effect before the sensor is installed, hence soldered on a board. Unfortunately, calibration algorithm used before soldering the sensor does not address or compensate for temperature coefficient offset resulting after soldering the sensor.

Accordingly, a need has arisen to calibrate the sensor after it is soldered on a board in order to address temperature coefficient offset. Furthermore, a need has arisen to address and remove liquid from the sensor environment when liquid is detected.

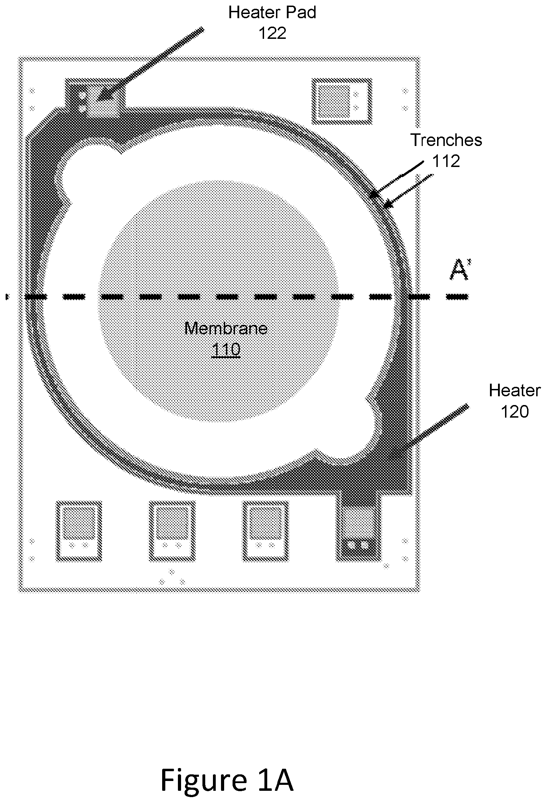

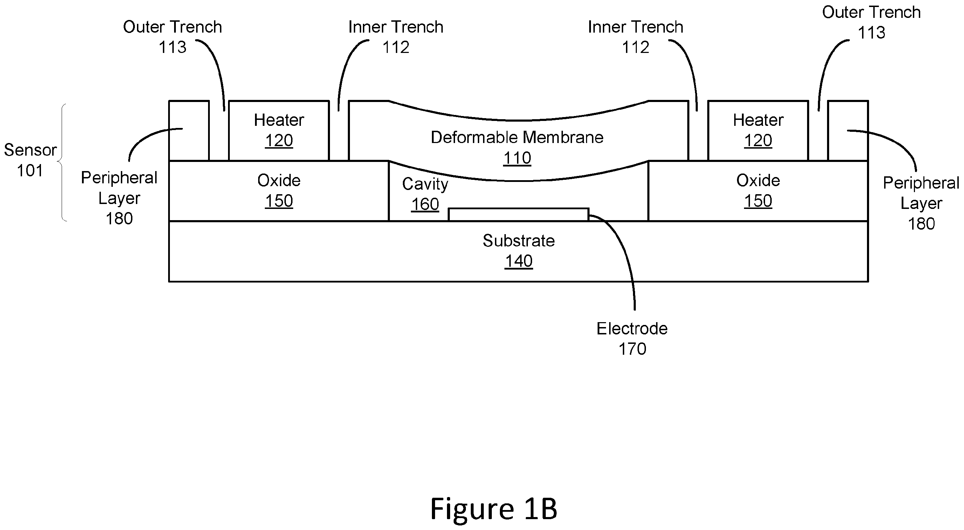

Referring now to Figures 1A-1B, a top view and a cross-sectional view of a sensor with heater integrated therein in accordance with some embodiments are shown. Referring specifically to Figure 1A, a deformable membrane 110 surrounded by a heater element 120 is shown. It is appreciated that the sensor device may be a microelectromechanical system (MEMS) sensor die. The MEMS sensor die comprises a deformable membrane 110, substrate 140, oxide 150, electrode 170, a heater element 120, trenches 112-113, and a peripheral layer 180, e.g., polysilicon layer. The heater 120 element may be generally referred to as a heater, MEMS heater, etc., throughout the instant application. The heater 120 may be integrated within a same layer and a same plane as the deformable membrane 110 (this is better illustrated in Figure 1B). It is appreciated that in some embodiments, the heater 120 may be separated from the deformable membrane 110 and from the peripheral layer 180 via trenches 112-113. In some embodiments, substrate 140 may comprise silicon. In other embodiment, substrate could be a CMOS substrate with electrical circuits. It is appreciated that the inner trench 112 (i.e. at the inner periphery) electrically isolates the heater 120 from the deformable membrane 110 while the outer trench 113 (i.e. at the outer periphery) separates the heater 120 and electrically isolates it from the peripheral layer 180. It is appreciated that the heater 120 may compose of a silicon ring that surrounds the deformable membrane 110. The deformable membrane 110 may be formed from a polysilicon layer.

The heater 120 may be coupled to the heater pad 122 in order to power the heater 120. It is appreciated that the heater 120 is configured to generate heat in order to heat the deformable membrane 110. In some embodiments, the heater 120 generates heat for calibration responsive to TCO after the MEMS sensor die is soldered on a board. For example, when an offset is detected the heater 120 may increase the temperature by 10° C increments in order to calibrate. It is appreciated that increasing the temperature by 10° C is for illustrative purposes and should not be construed as limiting the embodiments. For example, the heater 120 may be configured to heat up in 5° C increments, as an example. It is further appreciated that the calibration may occur responsive to a trigger, e.g., user request, meeting a certain threshold, etc. For example, the trigger may be a signal generated responsive to detecting presence of liquid on the deformable membrane, responsive to measuring an offset, responsive to measuring a temperature difference between the MEMS device and the substrate that is greater than a threshold amount, etc.

In some embodiments, the heater 120 element may be configured to generate heat responsive to detecting presence of liquid, e.g., water droplets, on the deformable membrane. For example, in some embodiments, the heater 120 may heat up to 100° C or slightly higher than that in order to heat up the deformable membrane 110 and cause water droplets on the deformable membrane 110 to evaporate. As such, any offset associated with presence of water droplets can be addressed by evaporating it. It is further appreciated that presence of water is for illustrative purposes and should not be construed as limiting the scope of the embodiments. For example, the embodiments are equally applicable to other forms of fluids, e.g., oil. It is appreciated that embodiments described herein can be applied to sensor devices that address liquid intrusion, as described in the U.S. Patent Application Number 16/520,228 and a U.S. Application Number 16/378,322, both of which are claimed the benefit and priority to and are incorporated herein by reference in their entirety.

Referring specifically to Figure 1B, a side view of a device with a heater integrated therein in accordance with some embodiments is shown. It is appreciated that the deformable membrane 110, the heater 120, and the trenches 112-113 are similar to that described in Figure 1A. In this embodiment, the heater 120 is within the same layer and plane as the deformable membrane 110. In this embodiment, the heater 120 is within the same layer and plane as the peripheral layer 180. According to some embodiments, the heater 120 and the peripheral layer 180 are deposited on an oxide layer 150. In some embodiment, heater 120 and deformable membrane 110 comprise of polysilicon. Furthermore, it is appreciated that the periphery of the deformable membrane 110 may be coupled to the upper surface of the oxide 150 layer. It is appreciated that the oxide layer 150 may be formed over a substrate 140, e.g., a silicon substrate. Accordingly, the deformable membrane 110 the oxide layer 150 and the substrate 140 form a cavity 160. The deformable membrane 110 may deflect responsive to a stimuli, e.g., pressure. In some embodiments, an electrode 170 may be formed over the upper surface of the substrate 140 that is disposed at the bottom of the cavity 160 facing the deformable membrane 110. The deformable membrane 110 may also include an electrode (not shown) for thereon or integrated therein. The electrode on the deformable membrane and electrode 170 for a capacitor. As such, deflection of the deformable membrane 110 changes the charges on the electrodes of the capacitor.

It is appreciated that in some embodiments the trenches 112 are within a passivation layer. It is appreciated that in some embodiments, the trenches 112 may be deposited with certain material such as Silicon Nitride, Silicon Oxide, etc. As illustrated, an inner trench and an outer trench are used. For example, the inner periphery trench is a trench disposed between deformable membrane 110 and the heater 120 while the outer periphery trench is a trench disposed between the heater 120 and the peripheral layer 180.

It is appreciated that the heater 120 is designed within a same layer as the surrounding sensor membrane, e.g., single crystalline silicon. Accordingly, a need to use any adjacent metal structure layers is eliminated, thereby reducing metal stress effect. Moreover, using the heater 120 enables the device to calibrate after the sensor is soldered on board or throughout its lifetime. It is also appreciated that use of the heater 120, as described, is a liquid ejection mechanism, e.g., by evaporating liquid such as water or oil. Moreover, it is appreciated that the heater 120, as described, surrounds the deformable membrane 110, thus creates temperature uniformity for the deformable membrane 110. However, it is appreciated that in some embodiments, the heater 120 may include a plurality of heaters that is separated by a gap therein or the heater 120 may not completely surround and encompass the deformable membrane 110. Thus, the heater 120 surrounding and encompassing the deformable membrane 110 is for illustrative purposes only and should not be construed as limiting the scope of the embodiments. It is appreciated that other structural configurations are shown in subsequent figures. It is also appreciated that in some embodiments another heater (not shown) may be used to heat the substrate 140 while the heater 120 may be used to heat the sensor 101 (i.e. MEMS device such as a pressure sensor) such that the heater 120 is used to selectively fine tune the temperature of the MEMS device by heating the deformable membrane 110 and to reduce the temperature difference between the substrate 140 and the MEMS device 101. It is appreciated that the calibration may occur responsive to a trigger, e.g., user request, meeting a certain threshold, etc. For example, the trigger may be a signal generated responsive to detecting presence of liquid on the deformable membrane, responsive to measuring an offset, responsive to measuring a temperature difference between the MEMS device and the substrate that is greater than a threshold amount, etc.

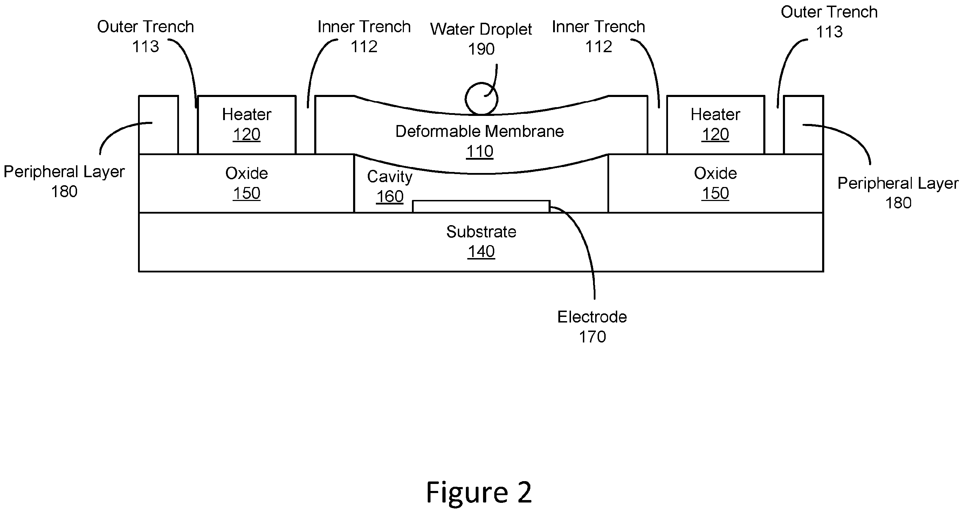

Figure 2 shows a sensor device with a heater integrated therein configured to heat to evaporate water droplets on its deformable membrane in accordance with some embodiments. Figure 2 is substantially similar to that of Figures 1A-1B. In this embodiment, a water droplet 190 is formed over the deformable membrane 110, thereby creating an offset and causing performance issues. It is appreciated that presence of water droplet 190 may have been detected by the device. As such, the heater 120 element may start heating up to 100° C or slightly above 100° C to heat the deformable membrane 110. As such, the water droplet 190 is evaporated in response thereto, thereby addressing any offsets created resulting from the water droplet 190.

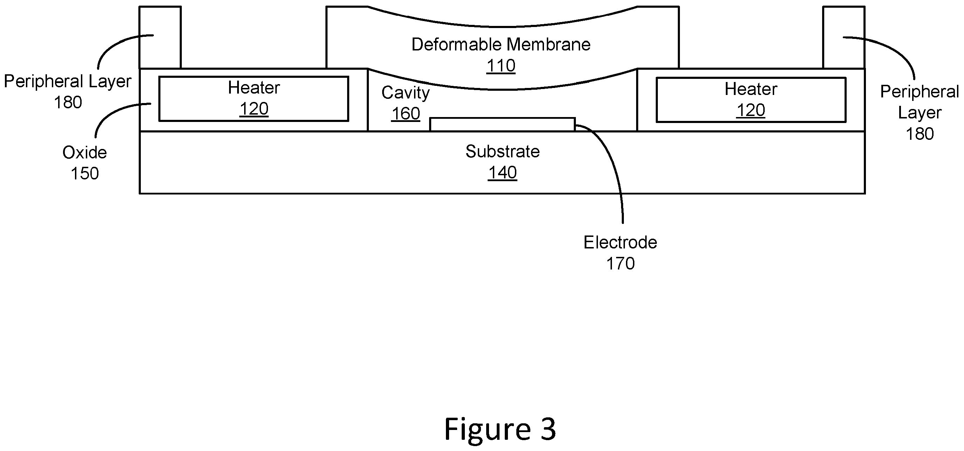

Referring now to Figure 3, another sensor device with a heater integrated therein in accordance with some embodiments is shown. Figure 3 is substantially similar to those described in Figures 1A-2. However, in this embodiment, the heater 120 is integrated within the oxide layer 150 instead of being within the same layer and plane as the deformable membrane 110 or the peripheral layer 180. In other words, the heater 120 is integrated within the oxide layer 150 and below the peripheral layer 180 and the deformable membrane 110.

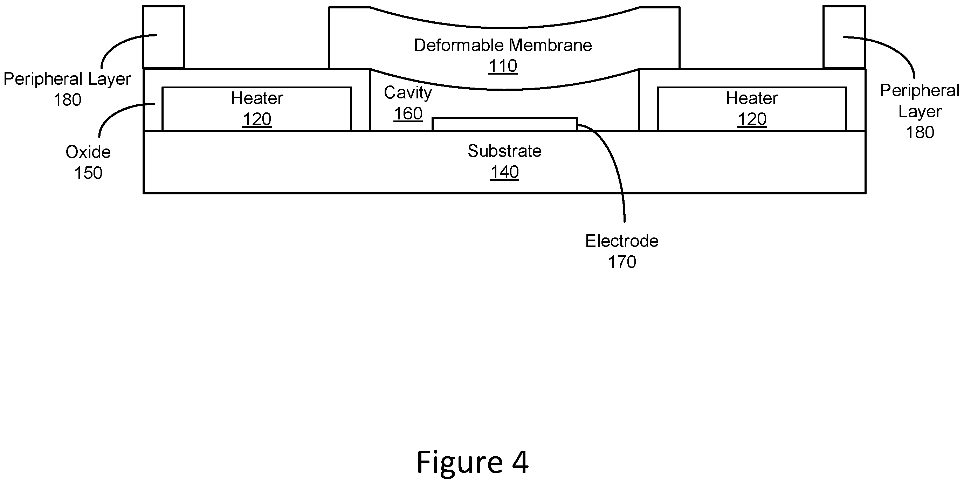

Referring now to Figure 4, yet another sensor device with a heater integrated therein in accordance with some embodiments is shown. Figure 4 is similar to that of Figure 3 except that in this embodiment, the lower surface of the heater 120 is in contact with the upper surface of the substrate 140.

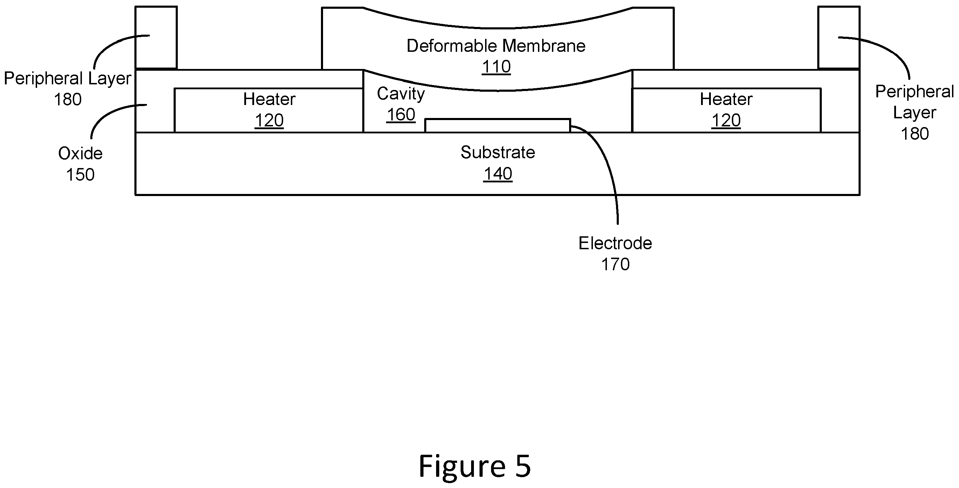

Referring now to Figure 5, an alternative sensor device with a heater integrated therein in accordance with some embodiments is shown. Figure 5 is similar that of Figure 4 except that at least one side of the heater 120 is exposed to the cavity 160. As such, the heater 120 heating up also heats up the cavity 160 and therefore the deformable membrane 110.

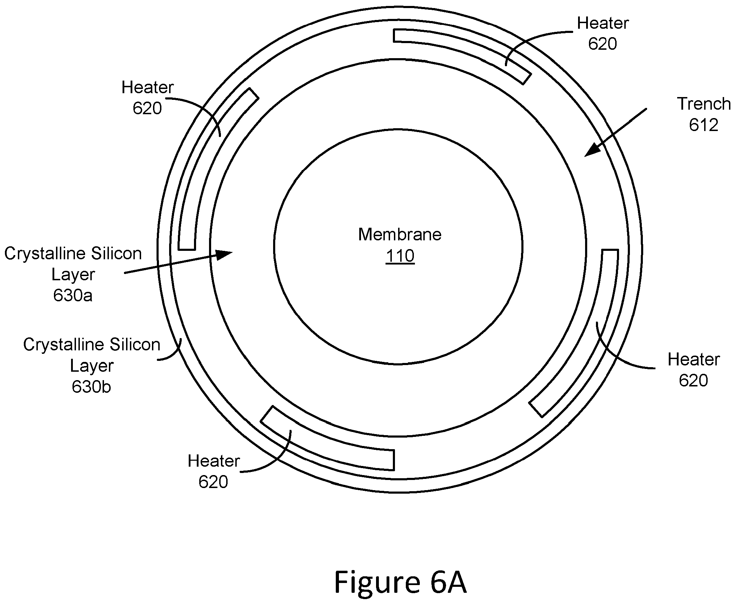

Referring now to Figure 6A, a top view of a sensor with different heater configuration integrated therein in accordance with some embodiments is shown. In this embodiment, four heaters are used, e.g., heaters 620. The heaters 620 are separated from one another through a gap or trench 612. The deformable membrane 110 is surrounded by an inner crystalline silicon layer 630a. It is appreciated that use of crystalline silicon layer is for illustrative purposes and should not be construed as limiting the embodiments. For example, a polysilicon layer may be used. The trench 612 separates the heaters 620 from the crystalline silicon layer 630a and the deformable membrane 110. It is appreciated that the trench 612 also separates the heaters 620 from the outer crystalline silicon layer 630b in order to provide electrical isolation with the peripheral layer (not shown here).

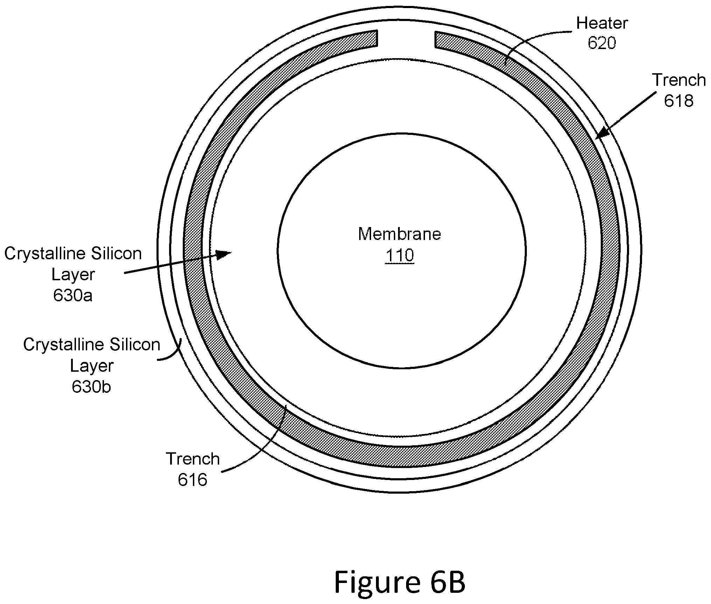

Referring now to Figure 6B, a top view of a sensor with different heater configuration integrated therein in accordance with some embodiments is shown. In this embodiment, a single heater 620 is used where it substantially surrounds the deformable membrane 110 without completely enclosing it. As such, the two ends of the heater 620 are separated from one another using a gap or a trench. The trench 616 separates the heater 620 from the inner crystalline silicon layer 630a whereas trench 618 separates the heater 620 from the outer crystalline silicon layer 630b. The trenches 612, 616 and/or 618 may be formed on a passivation layer and may include material such as Silicon Nitride, Silicon Oxide, etc.

Figures 6A and 6B are illustrated to show that the heater may have any shape or form. As such, a particular shape or the number of heaters used are for illustrative purposes only and should not be construed as limiting the embodiments. Accordingly, the sensor can calibrate after it is soldered on a board in order to address temperature coefficient offset. Furthermore, liquids can be removed from the sensor environment when liquid is detected by heating up the heater element and thereby the deformable membrane, thereby addressing any offset resulting from presence of the liquids. It is appreciated that the calibration may occur responsive to a trigger, e.g., user request, meeting a certain threshold, etc. For example, the trigger may be a signal generated responsive to detecting presence of liquid on the deformable membrane, responsive to measuring an offset, responsive to measuring a temperature difference between the MEMS device and the substrate that is greater than a threshold amount, etc.

## Claims

1. A device comprising:
a microelectromechanical system (MEMS) sensor die (101) comprising:
a deformable membrane (110);
a MEMS heating element (120) integrated within a same layer and a same plane as the deformable membrane;
wherein the MEMS heating element is disposed on the outer periphery of the deformable membrane;
wherein the MEMS heating element is electrically isolated from the deformable membrane by a trench (112);
wherein the MEMS heating element is configured to generate heat to heat up the deformable membrane;
wherein a material within the trench is selected from a group consisting of Silicon Nitride and Silicon Oxide.

2. The device of Claim 1, wherein the trench is within a silicon layer.

3. The device of Claim 1 further comprising another trench, wherein the another trench is positioned on an outer periphery of the MEMS heating element configured to electrically isolate the MEMS heating element from a peripheral layer.

4. The device of Claim 1, wherein a periphery of the deformable membrane is positioned on an oxide layer (150), and wherein the deformable membrane, the oxide layer, and a substrate (140) form a cavity (160), and wherein the substrate includes an electrode (170) that is formed on a top surface of the substrate that faces the deformable membrane within the cavity.

5. The device of Claim 4, wherein the MEMS heating element is disposed on the oxide layer.

6. The device of Claim 1, wherein the MEMS heating element is configured to generate heat for calibration responsive to temperature coefficient of offset (TCO).

7. The device of Claim 6, wherein the calibration is performed in response to a trigger.

8. The device of Claim 1, wherein the MEMS heating element is configured to generate heat responsive to detecting presence of liquid on the deformable membrane.

9. The device of Claim 1, further comprising a substrate.

10. The device of Claim 9 further comprising another MEMS heating element integrated within the same layer and the same plane as the deformable membrane, wherein the MEMS heating element and the another MEMS heating element are separated from one another, and wherein the another MEMS heating element is positioned on the periphery of the deformable membrane and is configured to generate thermal energy to heat up the deformable membrane.

11. The device of Claim 9, wherein the MEMS heating element has a gap therein, wherein the MEMS heating element surrounds the membrane without fully encompassing the deformable membrane.

12. The device of Claim 9, wherein a periphery of the deformable membrane is disposed on an oxide layer, and wherein the deformable membrane, the oxide layer, and the substrate form a cavity, and wherein the substrate includes an electrode that is formed on a top surface of the substrate that faces the deformable membrane within the cavity, and wherein the MEMS heating element is disposed on the oxide layer.

13. The device of Claim 9, wherein the MEMS heating element is configured to generate heat for calibration responsive to temperature coefficient of offset (TCO) after the MEMS sensor die is soldered on a board.

14. The device of Claim 9, wherein the MEMS heating element is configured to generate heat responsive to detecting presence of liquid on the deformable membrane.

## Patentansprüche

1. Vorrichtung, Folgendes umfassend:
einen mikroelektromechanischen Systemsensorchip, MEMS-Sensorchip, (101), Folgendes umfassend:
eine deformierbare Membran (110);
ein MEMS-Heizelement (120), das in eine gleiche Schicht und eine gleiche Ebene wie die deformierbare Membran integriert ist;
wobei das MEMS-Heizelement an der äußeren Peripherie der deformierbaren Membran angeordnet ist;
wobei das MEMS-Heizelement durch einen Graben (112) von der deformierbaren Membran elektrisch isoliert ist;
wobei das MEMS-Heizelement eingerichtet ist, um Wärme zu erzeugen, um die deformierbare Membran zu erwärmen;
wobei ein Material innerhalb des Grabens aus einer Gruppe ausgewählt ist, bestehend aus Siliziumnitrid und
Siliziumoxid.

2. Vorrichtung nach Anspruch 1, wobei der Graben in einer Siliziumschicht ist.

3. Vorrichtung nach Anspruch 1, weiterhin einen anderen Graben umfassend, wobei der andere Graben an einer äußeren Peripherie des MEMS-Heizelements positioniert ist und eingerichtet ist, um das MEMS-Heizelement von einer peripheren Schicht elektrisch zu isolieren.

4. Vorrichtung nach Anspruch 1, wobei eine Peripherie der deformierbaren Membran auf einer Oxidschicht (150) positioniert ist und wobei die deformierbare Membran, die Oxidschicht und ein Substrat (140) einen Hohlraum (160) ausbilden und wobei das Substrat eine Elektrode (170) umfasst, die auf einer oberen Oberfläche des Substrats ausgebildet ist, die der deformierbaren Membran in dem Hohlraum gegenübersteht.

5. Vorrichtung nach Anspruch 4, wobei das MEMS-Heizelement auf der Oxidschicht angeordnet ist.

6. Vorrichtung nach Anspruch 1, wobei das MEMS-Heizelement eingerichtet ist, um Wärme zur Kalibrierung als Reaktion auf einen Temperaturkoeffizient-Offset (TCO) zu erzeugen.

7. Vorrichtung nach Anspruch 6, wobei die Kalibrierung als Reaktion auf einen Trigger durchgeführt wird.

8. Vorrichtung nach Anspruch 1, wobei das MEMS-Heizelement eingerichtet ist, um Wärme als Reaktion auf ein Detektieren einer Gegenwart von Flüssigkeit auf der deformierbaren Membran zu erzeugen.

9. Vorrichtung nach Anspruch 1, weiterhin ein Substrat umfassend.

10. Vorrichtung nach Anspruch 9, weiterhin ein anderes MEMS-Heizelement umfassend, das in die gleiche Schicht und die gleiche Ebene wie die deformierbare Membran integriert ist, wobei das MEMS-Heizelement und das andere MEMS-Heizelement voneinander separiert sind und wobei das andere MEMS-Heizelement an der Peripherie der deformierbaren Membran positioniert ist und eingerichtet ist, um Wärmeenergie zu erzeugen, um die deformierbare Membran zu erwärmen.

11. Vorrichtung nach Anspruch 9, wobei das MEMS-Heizelement eine Lücke darin aufweist, wobei das MEMS-Heizelement die Membran umgibt, ohne die deformierbare Membran vollständig zu umschließen.

12. Vorrichtung nach Anspruch 9, wobei eine Peripherie der deformierbaren Membran auf einer Oxidschicht angeordnet ist und wobei die deformierbare Membran, die Oxidschicht und das Substrat einen Hohlraum ausbilden und wobei das Substrat eine Elektrode umfasst, die auf einer oberen Oberfläche des Substrats ausgebildet ist, die der deformierbaren Membran in dem Hohlraum gegenübersteht, und wobei das MEMS-Heizelement auf der Oxidschicht angeordnet ist.

13. Vorrichtung nach Anspruch 9, wobei das MEMS-Heizelement eingerichtet ist, um Wärme zur Kalibrierung als Reaktion auf einen Temperaturkoeffizient-Offset (TCO) zu erzeugen, nachdem der MEMS-Sensorchip auf eine Platine gelötet ist.

14. Vorrichtung nach Anspruch 9, wobei das MEMS-Heizelement eingerichtet ist, um Wärme als Reaktion auf ein Detektieren einer Gegenwart von Flüssigkeit auf der deformierbaren Membran zu erzeugen.

## Revendications

1. Dispositif comprenant :
une puce de capteur (101) à système microélectromécanique (MEMS) comprenant :
une membrane déformable (110) ;
un élément chauffant MEMS (120) intégré à l'intérieur d'une même couche et d'un même plan que la membrane déformable ;
dans lequel l'élément chauffant MEMS est disposé sur la périphérie externe de la membrane déformable ;
dans lequel l'élément chauffant MEMS est isolé électriquement de la membrane déformable par une tranchée (112) ;
dans lequel l'élément chauffant MEMS est configuré pour générer de la chaleur pour chauffer la membrane déformable ;
dans lequel un matériau à l'intérieur de la tranchée est choisi dans un groupe constitué par le nitrure de silicium et l'oxyde de silicium.

2. Dispositif selon la revendication 1, dans lequel la tranchée est à l'intérieur d'une couche de silicium.

3. Dispositif selon la revendication 1 comprenant en outre une autre tranchée, dans lequel l'autre tranchée est positionnée sur une périphérie externe de l'élément chauffant MEMS configurée pour isoler électriquement l'élément chauffant MEMS d'une couche périphérique.

4. Dispositif selon la revendication 1, dans lequel une périphérie de la membrane déformable est positionnée sur une couche d'oxyde (150), et dans lequel la membrane déformable, la couche d'oxyde et un substrat (140) forment une cavité (160), et dans lequel le substrat comporte une électrode (170) qui est formée sur une surface supérieure du substrat qui fait face à la membrane déformable à l'intérieur de la cavité.

5. Dispositif selon la revendication 4, dans lequel l'élément chauffant MEMS est disposé sur la couche d'oxyde.

6. Dispositif selon la revendication 1, dans lequel l'élément chauffant MEMS est configuré pour générer de la chaleur pour un étalonnage en réponse à un coefficient de température du décalage (TCO).

7. Dispositif selon la revendication 6, dans lequel l'étalonnage est effectué en réponse à un déclencheur.

8. Dispositif selon la revendication 1, dans lequel l'élément chauffant MEMS est configuré pour générer de la chaleur en réponse à la détection de la présence de liquide sur la membrane déformable.

9. Dispositif selon la revendication 1, comprenant en outre un substrat.

10. Dispositif selon la revendication 9 comprenant en outre un autre élément chauffant MEMS intégré à l'intérieur de la même couche et du même plan que la membrane déformable, dans lequel l'élément chauffant MEMS et l'autre élément chauffant MEMS sont séparés l'un de l'autre, et dans lequel l'autre élément chauffant MEMS est positionné sur la périphérie de la membrane déformable et est configuré pour générer de l'énergie thermique pour chauffer la membrane déformable.

11. Dispositif selon la revendication 9, dans lequel l'élément chauffant MEMS renferme un espace, dans lequel l'élément chauffant MEMS entoure la membrane sans enfermer entièrement la membrane déformable.

12. Dispositif selon la revendication 9, dans lequel une périphérie de la membrane déformable est disposée sur une couche d'oxyde, et dans lequel la membrane déformable, la couche d'oxyde et le substrat forment une cavité, et dans lequel le substrat comporte une électrode qui est formée sur une surface supérieure du substrat qui fait face à la membrane déformable à l'intérieur de la cavité, et dans lequel l'élément chauffant MEMS est disposé sur la couche d'oxyde.

13. Dispositif selon la revendication 9, dans lequel l'élément chauffant MEMS est configuré pour générer de la chaleur pour un étalonnage en réponse à un coefficient de température du décalage (TCO) après que la puce de capteur MEMS a été soudée sur une carte.

14. Dispositif selon la revendication 9, dans lequel l'élément chauffant MEMS est configuré pour générer de la chaleur en réponse à la détection de la présence de liquide sur la membrane déformable.
